# EUROPEAN PATENT APPLICATION

(11) **EP 4 618 084 A1**
(43) Date of publication of application: **17.09.2025**
(21) Application number: 25163703.9
(22) Date of filing: 14.03.2025
(51) Int. Cl.: G11C 11/02, G11C 11/16, G11C 17/02, G11C 17/14, G11C 17/18

(54) **MTJ ANTIFUSE WITH TRIM ENABLE AND METHOD OF OPERATION**

(30) Priority: 15.03.2024 US 202463566016 P; 04.03.2025 US 202519069541
(71) Applicant: Everspin Technologies, Inc., Chandler, Arizona 85226 (US)
(72) Inventor: XU, Haifeng, Chandler, AZ 85226 (US); SADD, Micheal A., Chandler, AZ 85226 (US); ZHANG, Xiaohu, Chandler, AZ 85226 (US); WILLIAMS, Jacob T., Chandler, AZ 85226 (US); ALAM, Syed M., Chandler, AZ 85226 (US); IKEGAWA, Sumio, Chandler, AZ 85226 (US); MANCOFF, Frederick B., Chandler, AZ 85226 (US); NAGEL, Kerry Joseph, Chandler, AZ 85226 (US)
(74) Representative: Eisenführ Speiser

(57) **Abstract**

A device may include a set of antifuse magnetic tunnel junctions (MTJs). A device may include a trim-enable MTJ associated with the set of antifuse MTJs, wherein each of the set of antifuse MTJs and the trim-enable MTJ has a logical state, the logical state being a first logical state or a second logical state. A device may include a circuit configured to determine the logical state of each of the set of antifuse MTJs and the trim-enable MTJ, wherein the logical state of each antifuse MTJ in the set of antifuse MTJs is read when the trim-enable MTJ has the second logical state, and wherein the logical state of every antifuse MTJ in the set of antifuse MTJs is determined to be the first logical state when the trim-enable MTJ has the first logical state.

## Description

### CROSS-REFERENCE TO RELATED APPLICATION

This application claims benefit to U.S. Provisional Patent Application No. 63/566,016 filed March 15, 2024, the entire contents of which are incorporated herein by reference.

### TECHNICAL FIELD

Various embodiments of the present disclosure relate generally to systems and methods for error mitigation in a memory device, and, more particularly, to systems and methods for reducing errors associated with antifuse in a magnetoresistive device.

### INTRODUCTION

In general, a memory system may include a memory device for storing data and a host (or controller) for controlling operations of the memory device. Memory devices may be classified into, e.g., volatile memory (such as, e.g., DRAM or SRAM) and non-volatile memory (such as EEPROM, FRAM (Ferroelectric RAM), PRAM (Phase-change memory), MRAM (magnetoresistive memory), RRAM/ReRAM (resistive memory) and Flash memory).

A magnetoresistive stack used in a memory device (e.g., MRAM) includes at least one non-magnetic layer (for example, at least one dielectric layer or a non-magnetic yet electrically conductive layer) disposed between a "fixed" magnetic region and a "free" magnetic region, each including one or more layers of ferromagnetic materials. Such a magnetoresistive stack is referred to as a magnetic tunnel junction (MTJ). Information is stored in the magnetoresistive memory stack by switching, programming, and/or controlling the direction of magnetization vectors in the magnetic layer(s) of the free magnetic region.

### BRIEF DESCRIPTION OF DRAWINGS

In the course of the detailed description that follows, reference will be made to the appended drawings. The drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present inventions.
FIG. 1 depicts an exemplary antifuse circuit, according to one or more embodiments of the present disclosure.
FIG. 2 depicts an exemplary graph illustrating resistance distribution of the exemplary antifuse circuit of FIG. 1, according to one or more embodiments.
FIG. 3 depicts an exemplary flow diagram illustrating a method of configuring trim-enable bits for error reduction, according to one or more embodiments.
FIG. 4A depicts an exemplary antifuse bock, according to one or more embodiments.
FIG. 4B depicts an exemplary group of bits within an antifuse bock, according to one or more embodiments.
FIG. 4C depicts an exemplary scan-chain circuitry, according to one or more embodiments.
FIG. 5A depicts a subsection of an exemplary scan-chain circuitry, according to one or more embodiments.
FIG. 5B depicts a subsection of an exemplary scan-chain circuitry, according to one or more embodiments.
FIG. 6 depicts an exemplary memory device including one or more antifuse blocks, according to one or more embodiments.

### DETAILED DESCRIPTION

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the terms "comprises," "comprising," or any other variation thereof, are intended to cover a non-exclusive inclusion, such that a process, method, article, or apparatus that comprises a list of elements does not include only those elements, but may include other elements not expressly listed or inherent to such process, method, article, or apparatus. The term "exemplary" is used in the sense of "example," rather than "ideal."

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. It should also be noted that all numeric values disclosed herein may have a variation of ±10% (unless a different variation is specified) from the disclosed numeric value. Further, all relative terms such as "about," "substantially," "approximately," etc. are used to indicate a possible variation of ±10% (unless noted otherwise or another variation is specified).

In one embodiment, the present disclosure is directed to techniques and implementations for error mitigation in a memory device, and, more particularly, to systems and methods for a magnetoresistive device including antifuse magnetic tunnel junctions (MTJs) and trim-enable MTJs, each trim-enable MTJ associated with a corresponding set of antifuse MTJs for error mitigation.

One or more embodiments of the present disclosure may describe a unit of a memory array including an MTJ, which may include, among other things, two magnetic layers on opposite sides of an insulator. Manufacturing defects may leave some memory units (e.g., bits or MTJs) in an array with electrical shorts or partial electrical shorts (also referred to herein as simply shorts and partial shorts, respectively), thereby causing low device performance or even failure. Shorts or partial shorts may occur in an MTJ when it permanently conducts an electrical current due to, e.g., defects in the insulator layer, insulator breakdown, etc., which causes the two magnetic layers to be in electrical contact and therefore conduct. If more than a threshold number of MTJs in an array are shorted or partially shorted, the entire memory device (e.g., an integrated circuit (IC) memory chip) may be considered defective.

MTJs are typically unprogrammed initially, because programming takes time and consumes energy. Thus, the default output of a given MTJ is a logical 0 (e.g., unprogrammed), and relatively few antifuse bits are programmed based on data storage needs. Manufacturing defects cause unprogrammed MTJs to be electrically shorted or partially electrically shorted (e.g., have a low conductive resistance), which may cause unprogrammed MTJs to erroneously be read as programmed. Thus, after manufacturing, any short or partial short defects will act as a programmed antifuse (e.g., the antifuse will permanently conduct). For example, in case of 10,000 total bits on a memory chip, if any one bit has a defect, the chip will need to be screened out. Accordingly, it is desirable to have a memory device that allows for a high defect rate which leads to improved yield, while reducing erroneous readings and energy consumption.

One or more embodiments of this disclosure may provide error prevention or reduction in magnetoresistive random access memory (MRAM) antifuse circuitry, which may improve chip yields and performance.

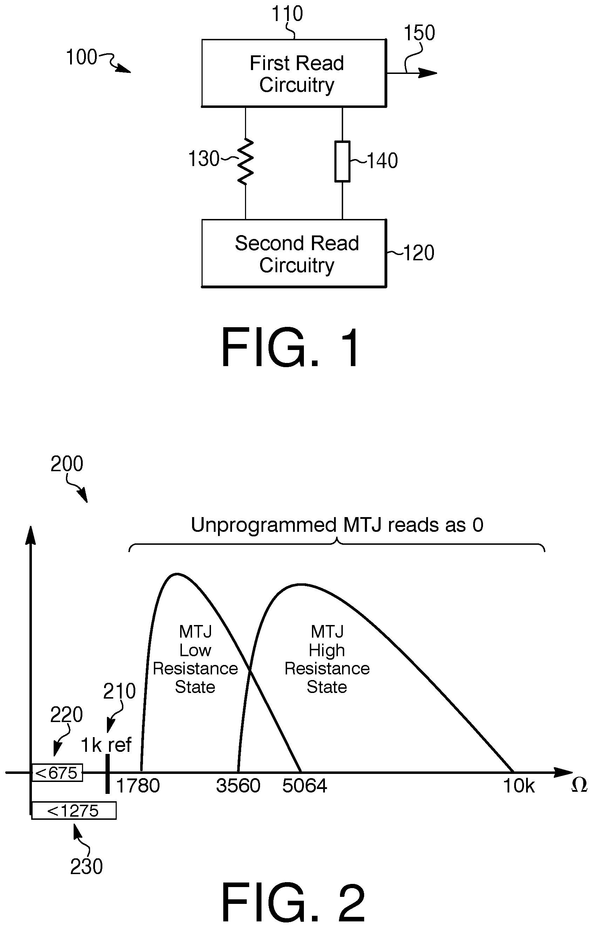

FIG. 1 shows an exemplary antifuse MTJ circuit 100. The antifuse MTJ circuit 100 may include a first read circuitry 110, a second read circuitry 120, a reference resistor 130, an MTJ 140, and an output 150. The MTJ 140 may be in a programmed (e.g., logical 1) or an unprogrammed (e.g., logical 0) state. The first read circuitry 110 and the second read circuitry 120 may compare the resistance of the reference resistor 130 with respect to the MTJ 140 to determine the state of the antifuse MTJ circuit 100. In one embodiment, the reference resistor 130 may include a polysilicon resistor. If the MTJ 140 is programmed to be a short (e.g., conduct an electrical current), then the output 150 may be read as a logical 1 (also referred to herein as a programmed state). If the MTJ 140 is unprogrammed, the output 150 may be read as a logical 0 (also referred to herein as an unprogrammed state).

FIG. 2 illustrates an exemplary graph 200 illustrating resistance distribution of an antifuse circuit (e.g., antifuse MTJ circuit 100). The graph 200 shows the conductive resistance in an MTJ corresponding to logical states of the MTJ (e.g., logical 1 or logical 0). As an example, a reference polysilicon resistor (e.g., reference resistor 130) may include a reference resistance 210 of approximately 1,000Ω. During operation, while the unprogrammed MTJ resistance may vary between approximately 1,780Ω to approximately 10,000Ω. However, a programmed MTJ resistance 220 (e.g., less than approximately 675Ω, in the example illustrated in FIG. 2) may be less than the reference resistance 210 (e.g., less than approximately 1,000Ω), which may allow the MTJ to conduct an electrical current. As previously mentioned, due to defects, an unprogrammed MTJ may be shorted or partially shorted with a shorted MTJ resistance 230 (e.g., less than approximately 1,275Ω), causing the MTJ to include a resistance less than the unprogrammed resistance range (e.g., less than 1,780Ω) and, more significantly, less than the reference resistance 210 of approximately 1,000Ω. Thus, defects that may cause shorts and partial shorts may cause unprogrammed MTJs to be erroneously read as programmed because shorted MTJs may conduct electricity due to a similar resistance range as that of programmed MTJs.

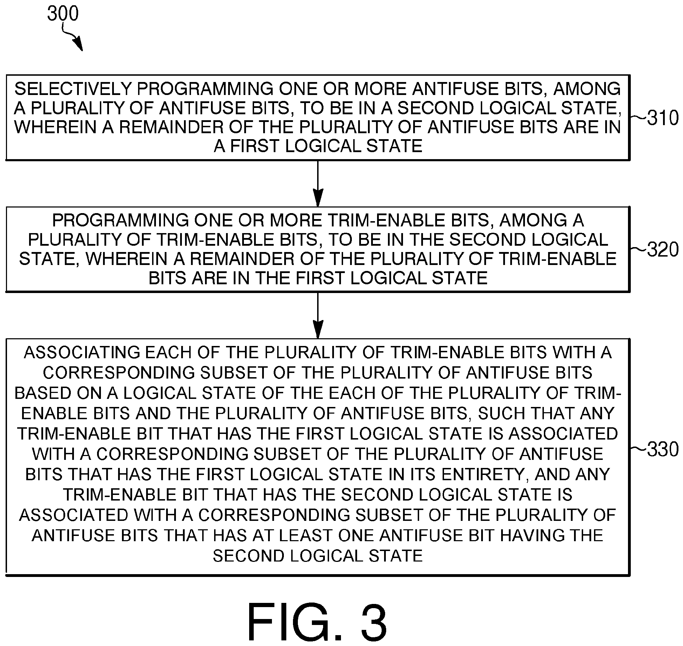

FIG. 3 illustrates exemplary method 300 for selectively programming one or more bits within a memory array. More particularly, the method 300 illustrates a method of configuring trim-enable bits for error reduction in a memory device. The method 300 may start with step 310, by selectively programming one or more antifuse bits, among a plurality of antifuse bits, to be in a second logical state (e.g., logical 1), wherein a remainder of the plurality of antifuse bits are in a first logical state (e.g., logical 0).

At step 320, the method 300 may further include programming one or more trim-enable bits, among a plurality of trim-enable bits, to be in the second logical state, wherein a remainder of the plurality of trim-enable bits are in the first logical state.

At step 330, the method may further include associating each of the plurality of trim-enable bits with a corresponding subset of the plurality of antifuse bits based on a logical state of the each of the plurality of trim-enable bits and the plurality of antifuse bits, such that any trim-enable bit that has the first logical state is associated with a corresponding subset of the plurality of antifuse bits that has the first logical state in its entirety (meaning that all of the antifuse bits in the subset have the first logical state), and any trim-enable bit that has the second logical state is associated with a corresponding subset of the plurality of antifuse bits that has at least one antifuse bit having the second logical state.

Alternative to steps 320 and 330 discussed above, the method 300 may include determining a first subset of the plurality of antifuse bits that has the first logical state in its entirety (meaning that all of the antifuse bits in the first subset have the first logical state), and associating the first subset of the plurality of antifuse bits with a trim-enable bit that has the first logical state. The method 300 may further include determining a second subset of the plurality of antifuse bits that has at least one antifuse bit having the second logical state), and associating the second subset of the plurality of antifuse bits with a trim-enable bit that has the second logical state. The number of antifuse bits included in each subset may be the same across all subsets, or may be different between subsets.

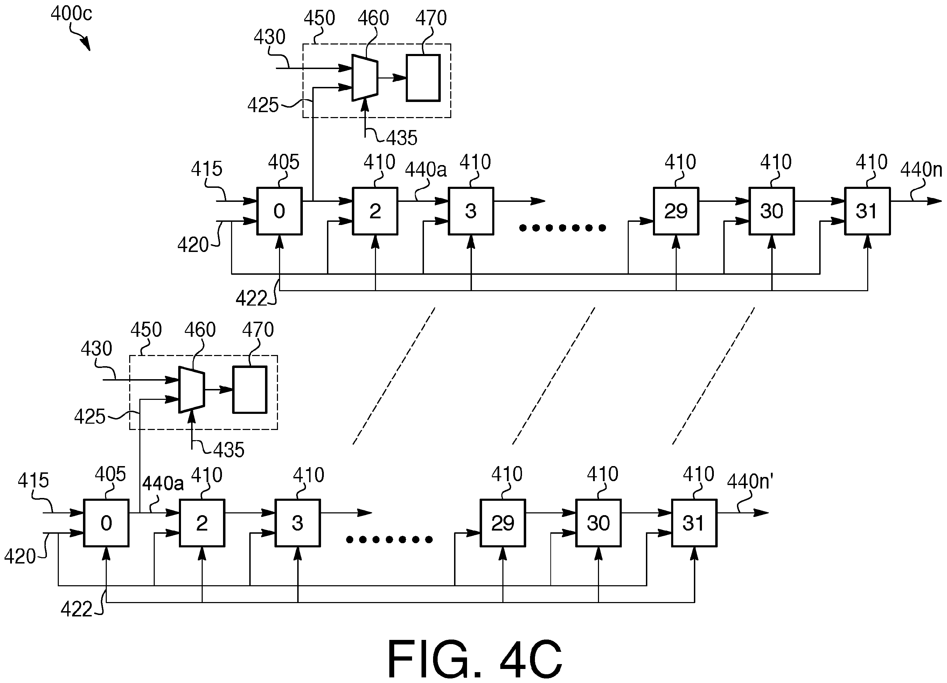

In this way, based on which bit is selectively programmed (e.g., trim-enable or antifuse bit), the circuit (e.g., using a scan-chain circuitry, such as the one illustrated in reference to FIG. 4C) may determine, based on the association of the trim-enable bits to the corresponding subsets of the plurality of antifuse bits, whether to read the state of each individual antifuse bit in a subset, or to assume that all of the antifuse bits in the subset are of the first logical state. For example, if a trim-enable bit associated with a subset of the plurality of antifuse bits has the first logical state, the circuit may simply determine that all of the antifuse bits in the subset have the first logical state. On the other hand, if a trim-enable bit associated with a subset of the plurality of antifuse bits has the first logical state, the circuit may read each individual antifuse bit in the subset to determine its state.

Accordingly, the method 300 may further include determining the logical state of each of the plurality of trim-enable bits and upon determining the logical state of a trim-enable bit is in the first logical state, concluding that the corresponding subset of the plurality of antifuse bits have the first logical state in its entirety. For example, if the trim-enable bit is determined to be in the first logical state (e.g., logical 0), all of the antifuse bits in the corresponding subset are assumed to be in the same, first logical state (e.g., logical 0). Therefore, if the trim-enable bit associated with a subset of the plurality of antifuse bits is in the first logical state, the actual state of each of the plurality of antifuse bits in the corresponding subset is ignored, and the antifuse MTJ bits in the subset are determined (e.g., assumed) to be the same, first logical state as the trim-enable bit (e.g., logical 0).

Additionally, the method 300 may further include determining the logical state of each of the plurality of trim-enable bits and upon determining the logical state of a trim-enable bit is in the second logical state, reading the logical state of the each antifuse bit in the corresponding subset of the plurality of antifuse bits. For example, if the trim-enable bit is determined to be in the second logical state (e.g., logical 1), the circuit may read each individual antifuse bit in the corresponding subset of the plurality of antifuse bits to determine its state.

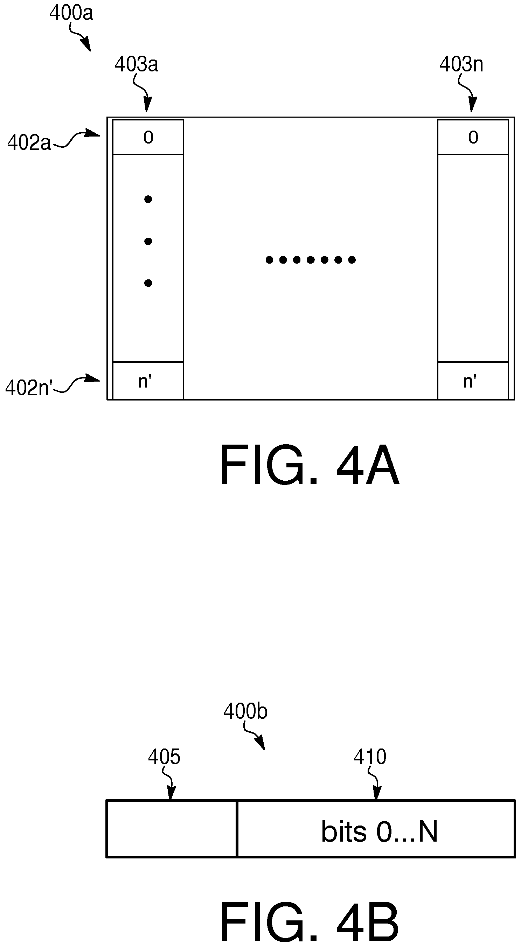

FIG. 4A illustrates an exemplary antifuse block 400a. The antifuse block 400a may include one or more rows 402a-402n' and one or more columns 403a-403n. For example, the antifuse block 400a may include 10 columns and 32 rows of antifuse MTJ bits and/or trim-enable MTJ bits. However, the size or the dimension of the antifuse block 400a is not limited thereto, and may comprise any number of columns and rows. Each column may be associated with (e.g., connected to) a scan chain, where the scan-chain may include 32 registers to store the bits from each column.

FIG. 4B illustrates an exemplary group 400b of MTJ bits. The group 400b may include a trim-enable bit 405 and antifuse bits 410, each bit in the form of an MTJ (thus referred to herein also as trim-enable MTJ bits and antifuse MTJ bits, respectively). The trim-enable bit 405 may be introduced into the memory array to indicate whether associated antifuse bits within the array should be read. The trim-enable bit 405 may be a programmable bit on which the readability of associated antifuse bits within the memory array is dependent. Programming a trim-enable bit 405 may include, for example, changing the state of the trim-enable bit 405 from one logical state (e.g., logical 0) to another logical state (e.g., logical 1) by making the trim-enable bit 405 electrically conduct. If a trim-enable bit 405 is programmed, the logical states of the antifuse bits 410 in the same group 400b as the trim-enable bit 405 may be read. That is, the trim-enable bit 405 may be part of a larger array of bits in, for example, a scan chain, as shown in FIG. 4C below.

FIG. 4C illustrates an exemplary operation of a scan-chain circuitry 400c. Each scan-chain may be associated with a corresponding column (e.g., one of columns 403a-403n) of the antifuse block 400a, and may comprise a n'-bit scan test register for fuse read (e.g., in the example of FIG. 4C, a 34-bit scan test register). A scan-chain may be configured to load one or more trim-enable bits 405, and one or more antifuse bits 410 associated with each of the one or more trim-enable bits 405. A scan-chain may include a flip-flop corresponding to each of the trim-enabled bit 405 and the antifuse bits 410. A scan-chain may be configured to load a single group of bits (e.g., group 400b) or multiple groups of bits during operation. A scan-chain may include an input 415, a ftmclk 420, a parallel input/output 422, a trim-enable bit output 425, a metal default 430, a MUX selector 435, an output to next flip-flop 440a-440n', and a trim-enable decision block 450. The input 415 may include values loaded from the antifuse block (e.g., 400a). The output to next flip-flop 440a-440n may be the input for the following flip-flop, as similarly described with respect to input 415. The ftmclk 420 may include a "functional to mode" clock signal configured to shift data though the scan-chain based on the clock input value. The parallel input/output 422 may provide a parallel input/output to each of the bits of the flip-flops. The trim-enable bit output 425 may include the value or the logical state of the trim-enable bit 405 (e.g., logical 1 or logical 0).

The trim-enable bit decision block 450 may include a MUX 460 and an output circuit 470. The MUX 460 may be configured to determine whether to select the metal default 430 value or the values within the scan-chain based on the trim-enable bit output 425. The MUX 460 may be configured to receive the metal default 430, the trim-enable bit output 425, and the MUX selector 435. The metal default 430 may be a predetermined value and used depending on the value of the MUX selector 435. The MUX selector 435 may be configured to provide whether to use the trim-enable bit 405 value or read the values for each of the antifuse bits 410 within the group 400b. For example, if the trim-enable bit 405 is programmed (e.g., logical 1), the MUX selector 435 will provide a value to the MUX 460 indicative of selecting the trim-enable bit output 425 for reading the values of each antifuse bit 410 within the corresponding group 400b. If the trim-enable bit 405 is not programmed (e.g., logical 0), the MUX selector 435 will provide a value to the MUX 460 indicative of not selecting the trim-enable bit output 425 for disregarding the values of each antifuse bit 410 within the corresponding group 400b and use the metal default 430. In one embodiment, the metal default 430 may lead to all of the antifuse bits to be represented by logical 0's. In other embodiments, the metal default 430 may lead to all of the antifuse bits to be represented by logical 1's. In further embodiments, the metal default 430 may lead to the antifuse bits to be represented by a predetermined sequence of logical states, comprising both logical 0 and logical 1.

If the trim-enable bit 405 is not programmed (e.g., a logical 0), each antifuse bit 410 within the group 400b may be read as unprogrammed by other circuitry. Thus, potential shorts or partial shorts in the antifuse bits 410 in the group 400b may be ignored. If the trim-enable bit 405 has a short or partial short and is erroneously read as programmed, then each antifuse bit 410 within the group 400b may still be programmed to a desired state and read by other circuitry. Thus, at least one short or partial short in group 400b may be allowed to be present without impacting performance or reliability of the integrated circuit chip, thereby increasing manufacturing yields. For example, if the group 400b has a size of 13 bits, where there is one trim-enable bit 405 and 12 antifuse bits 410 within the group 400b, a defect rate less than or equal to 1/13 is acceptable, thereby allowing a higher defect rate for increased yield. In another embodiment, each group 400b may include more than one trim-enable bit 405 (e.g., up to 3 trim-enable bits, or more).

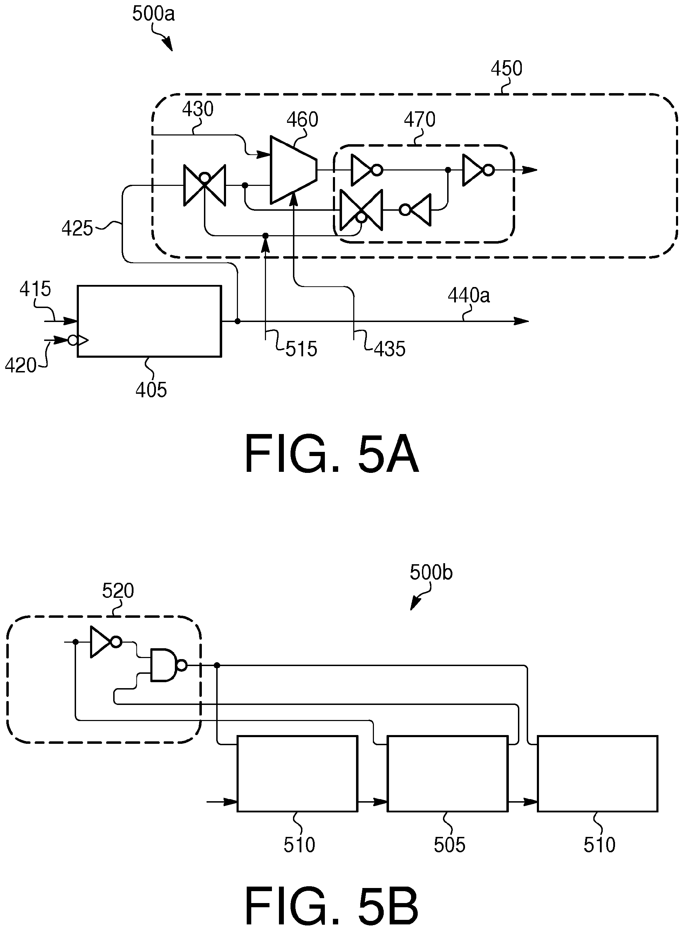

FIG. 5A illustrates a trim-enable scan-chain subsection 500a of a scan-chain (e.g., of the scan-chain circuitry 400c). The trim-enable scan-chain subsection 500a may be configured to determine whether or not to use the trim-enable bit (e.g., trim-enable bit 405) when reading the bit values of each group of bits (e.g., group 400b) within the antifuse block (e.g., 400a). The trim-enable scan-chain subsection 500a may be configured to perform similar or substantially similar operations as described above in FIG. 4C with respect to the scan-chain circuitry 400c, and in particular, the trim-enable decision block 450. The trim-enable bit decision block 450 may include a MUX 460 and an output circuit 470 as described above. The MUX 460 may be configured to choose whether to select the metal default 430 value or the values within the scan-chain based on the trim-enable bit output 425. The MUX 460 may be configured to receive the metal default 430, the trim-enable bit output 425, and the MUX selector 435. The metal default 430 may be a predetermined value and used depending on the value of the MUX selector 435. The MUX selector 435 may be configured to provide whether to use the trim-enable bit 405 value or read the values for each of the antifuse bits 410 within the corresponding group 400b. For example, if the trim-enable bit 405 is programmed (e.g., logical 1), the MUX selector 435 will provide a value to the MUX 460 indicative of selecting the trim-enable bit output 425 for reading the values of each antifuse bit 410 within the corresponding group 400b. If the trim-enable bit 405 is not programmed (e.g., logical 0), the MUX selector 435 will provide a value to the MUX 460 indicative of not selecting the trim-enable bit output 425 for disregarding the values of each antifuse bit 410 within the corresponding group 400b and use the metal default 430. The output circuit 470 may be configured to receive the MUX 460 output in addition to ftmlook 515. The output circuit 470 may be configured to generate a parallel output to circuit output input. For example, the output circuit 470 may generate an output that may be used similarly as the output to next flip-flop 440a-440n'.

The trim-enable bit (e.g., 405) may be programmed before the logical states of the other bits in the group (e.g., 400b) are read. If the trim-enable bit is a logical 0, the whole group of bits may become the metal default. Shorts or partial shorts in antifuse bits may not impact the logical states read by other circuitry, unless the trim-enable bit is also shorted or partially shorted.

In some embodiments, the trim-enable bit may include 3 or more bits (not shown) instead of 1. Thus, triple modular redundancy (TMR) may be applied to take a majority vote of 3 trim-enable bits, allowing 1 of the 3 trim-enable bits to have a short or partial short. Error correction code (ECC), which may be an algorithmic error correction method, may also be applied in some implementation using the bits from trim-enable bit and associated antifuse bits in that trim-enable group. ECC may allow for correcting any fails (e.g., shorts or partial shorts) in the group.

FIG. 5B illustrates another subsection of the scan-chain circuitry 400c, a scan-chain subsection 500b. The scan-chain subsection 500b may include a trim-enable bit flip-flop 505, one or more antifuse bit flip-flops 510, and decision block 520. The output from the trim-enable bit flip-flop 505 may be received by the decision block 520, where the decision block 520 may be configured to determine if the trim-enable bit flip-flop 505 value may be used by each of the corresponding antifuse bit flip-flops 510 within the scan-chain subsection 500b. It should be apparent to a person of ordinary skill in the art that any of the flip-flops (e.g., 505 or 510) and decision block 520 may be implemented with different types of circuitry not mentioned herein, however, performing a similar generic function such as flip-flops for storage and a decision block for decision logic.

The scan-chain subsection 500b may include a flip-flop for each of the trim-enable bit(s) and the antifuse bits of the group of trim-enable bit(s) and antifuse bits. For example, a group of trim-enable antifuse bits may include 16 bits, 32 bits, or more. In such group, one or more trim-enable bits may be present, with the remaining bits being the antifuse bits. As an example, when a group includes 16 bits, 3 bits may be trim-enable bits while the remaining 13 bits will be antifuse bits. A single column of bits in the antifuse block 400a may include one or more groups of trim-enable and antifuse bits. The ratio of trim-enable bit(s) to antifuse bits in a group can be customized depending on the application and/or the error rate required.

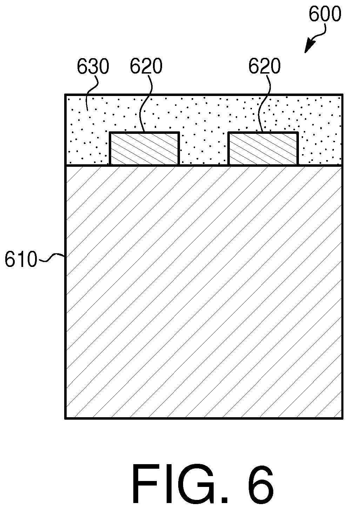

FIG. 6 illustrates an exemplary memory device 600. The memory device 600 may include magnetoresistive random access memory (MRAM) array 610, one or more MTJ antifuse blocks 620 (such as the ones depicted in FIG. 4A), and a tiled MTJ area 630. The one or more MTJ antifuse blocks 620 may be disposed in close proximity to, or may abut, the MRAM array 610. In addition, the one or more MTJ antifuse blocks 620 may be placed on a substrate (not shown), and the pattern of the one or more MTJ antifuse blocks 620 may be uniform to reduce defects in the memory device 600. Additionally, the one or more MTJ antifuse blocks 620 may be surrounded by a tiled MTJ area 630 which may be tiled with MTJ fill patterns, providing improved uniformity.

In an embodiment, the one or more MTJ antifuse blocks 620 may be positioned within the MRAM memory array 610 on different wordlines or bitlines, for example, to improve uniformity. Improved uniformity may reduce defects in the one or more MTJ antifuse blocks 620.

Other methods for reducing defects in the one or more MTJ antifuse blocks 620 may include implementing MTJs of different shapes or geometries in the MTJ antifuse blocks 620. For example, the MTJs in the MTJ antifuse blocks 620 may be larger or smaller relative to the MTJs in the main array (e.g., the MRAM array 610), providing a reduction of certain types of defects. In one embodiment, the MTJs in the MRAM array 610 may be approximately 0.2 micrometers by 0.2 micrometers in size. Implementing relatively smaller MTJs in the antifuse blocks 620 may reduce bridge defects (e.g., electrical shorts). On the other hand, implementing larger MTJs in the antifuse blocks 620 may reduce any defect due to metal via landing. The size of the MTJs within the MTJ antifuse block may be determined depending on the types of defects commonly present in a manufacturing process.

In one embodiment, the present disclosure is drawn to a magnetoresistive device comprising: a set of antifuse magnetic tunnel junctions (MTJs); a trim-enable MTJ associated with the set of antifuse MTJs, wherein each of the set of antifuse MTJs and the trim-enable MTJ has a logical state, the logical state being a first logical state or a second logical state; and a circuit configured to determine the logical state of each of the set of antifuse MTJs and the trim-enable MTJ, wherein the logical state of each antifuse MTJ in the set of antifuse MTJs is read when the trim-enable MTJ has the second logical state, and wherein the logical state of every antifuse MTJ in the set of antifuse MTJs is determined to be the first logical state when the trim-enable MTJ has the first logical state.

Various aspects of the present disclosure may also include wherein the trim-enable MTJ includes at least three MTJs; wherein a triple modular redundancy is applied to take a majority vote of at least three MTJs in the trim-enable MTJ to determine whether or not the trim-enable MTJ is programmed to the second logical state; wherein the set of antifuse MTJs includes a 32-bit MTJ array; wherein the trim-enable MTJ and the set of antifuse MTJs are positioned proximate a memory array; wherein an area surrounding the trim-enable MTJ and the set of antifuse MTJs is tiled with an MTJ fill pattern; wherein the trim-enable MTJ and the set of antifuse MTJs are included within a memory array; and wherein each of the trim-enable MTJ and the set of antifuse MTJs includes a size that is smaller or larger than a size of a typical MTJ.

In another embodiment, the present disclosure is drawn to a magnetoresistive device comprising: a memory array including a plurality of magnetic tunnel junctions (MTJs); and at least one antifuse block including one or more groups of trim-enable and antifuse MTJs, wherein each group of the one or more group of trim-enable and antifuse MTJs includes at least one trim-enable MTJ and at least one antifuse MTJ.

Various aspects of the present disclosure may also include wherein the at least one antifuse block is positioned adjacent the memory array; wherein a size of each of the plurality of MTJs in the memory array is different from a size of each of the trim-enable and antifuse MTJs in the at least one antifuse block; wherein the plurality of MTJs in the memory array are placed on different wordlines and bitlines from those of the trim-enable and antifuse MTJs in the at least one antifuse block; wherein an area surrounding the at least one antifuse block is tiled with an MTJ fill pattern; the magnetoresistive device further including: a circuit configured to determine a logical state of each of the at least one trim-enable MTJ and at least one antifuse MTJ in each group, wherein the logical state of the at least one antifuse MTJ in the group is read when the at least one trim-enable MTJ in the group has a second logical state, and wherein the logical state of the at least one antifuse MTJ is determined to be a first logical state when the at least one trim-enable MTJ has the first logical state; and the magnetoresistive device further including: a circuit configured to determine a logical state of each of the at least one trim-enable MTJ and at least one antifuse MTJ, wherein the circuit includes one or more scan-chains.

In yet another embodiment, the present disclosure is drawn to a method comprising: selectively programming one or more antifuse bits, among a plurality of antifuse bits, to be in a second logical state, wherein a remainder of the plurality of antifuse bits are in a first logical state; programming one or more trim-enable bits, among a plurality of trim-enable bits, to be in the second logical state, wherein a remainder of the plurality of trim-enable bits are in the first logical state; and associating each of the plurality of trim-enable bits with a corresponding subset of the plurality of antifuse bits based on a logical state of the each of the plurality of trim-enable bits and the plurality of antifuse bits, such that any trim-enable bit that has the first logical state is associated with a corresponding subset of the plurality of antifuse bits that has the first logical state in its entirety, and any trim-enable bit that has the second logical state is associated with a corresponding subset of the plurality of antifuse bits that has at least one antifuse bit having the second logical state.

Various aspects of the present disclosure may also include the method further comprising: determining the logical state of each of the plurality of trim-enable bits to determine subsequent actions to be performed with respect to the corresponding subset of the plurality of antifuse bits; the method further comprising: determining the logical state of each of the plurality of trim-enable bits; and upon determining the logical state of a trim-enable bit is in the first logical state, determining that the corresponding subset of the plurality of antifuse bits have the first logical state in its entirety; the method further comprising: determining the logical state of each of the plurality of trim-enable bits; and upon determining the logical state of a trim-enable bit is in the second logical state, reading the logical state of each antifuse bit in the corresponding subset of the plurality of antifuse bits; and wherein the one or more antifuse bits and the one or more trim-enable bits comprise one or more magnetic tunnel junctions (MTJs).

Other embodiments of the disclosure will be apparent to those skilled in the art from consideration of the specification and practice of the embodiment(s) disclosed herein. It is intended that the specification and examples be considered as exemplary only, with a true scope and spirit of the embodiment(s) being indicated by the following claims.

While exemplary embodiments have been presented above, it should be appreciated that many variations exist. Furthermore, while the description includes references to MRAM devices, the teachings may be applied to other memory devices having different architectures in which the same concepts can be applied. Thus, the particular embodiments disclosed above are illustrative only and should not be taken as limitations, as the embodiments may be modified and practiced in different but equivalent manners apparent to those skilled in the art having the benefit of the teachings herein. Accordingly, the foregoing description is not intended to limit the disclosure to the particular form set forth, but on the contrary, is intended to cover such alternatives, modifications and equivalents as may be included within the spirit and scope of the inventions as defined by the appended claims so that those skilled in the art should understand that they can make various changes, substitutions and alterations without departing from the spirit and scope of the inventions in their broadest form.

The foregoing description of the inventions has been described for purposes of clarity and understanding. It is not intended to limit the inventions to the precise form disclosed. Various modifications may be possible within the scope and equivalence of the application.

## Claims

1. A magnetoresistive device comprising:
a set of antifuse magnetic tunnel junctions (MTJs);
a trim-enable MTJ associated with the set of antifuse MTJs, wherein each of the set of antifuse MTJs and the trim-enable MTJ has a logical state, the logical state being a first logical state or a second logical state; and
a circuit configured to determine the logical state of each of the set of antifuse MTJs and the trim-enable MTJ, wherein the logical state of each antifuse MTJ in the set of antifuse MTJs is read when the trim-enable MTJ has the second logical state, and wherein the logical state of every antifuse MTJ in the set of antifuse MTJs is determined to be the first logical state when the trim-enable MTJ has the first logical state.

2. The magnetoresistive device of claim 1, wherein the trim-enable MTJ includes at least three MTJs.

3. The magnetoresistive device of claim 1 or 2, wherein a triple modular redundancy is applied to take a majority vote of at least three MTJs in the trim-enable MTJ to determine whether or not the trim-enable MTJ is programmed to the second logical state.

4. The magnetoresistive device of one of claims 1 to 3, wherein the set of antifuse MTJs includes a 32-bit MTJ array, and/or wherein the trim-enable MTJ and the set of antifuse MTJs are positioned proximate a memory array, and/or wherein an area surrounding the trim-enable MTJ and the set of antifuse MTJs is tiled with an MTJ fill pattern.

5. The magnetoresistive device of one of claims 1 to 4, wherein the trim-enable MTJ and the set of antifuse MTJs are included within a memory array, in particular wherein each of the trim-enable MTJ and the set of antifuse MTJs includes a size that is smaller or larger than a size of a typical MTJ.

6. A magnetoresistive device comprising:
a memory array including a plurality of magnetic tunnel junctions (MTJs); and
at least one antifuse block including one or more groups of trim-enable and antifuse MTJs,
wherein each group of the one or more group of trim-enable and antifuse MTJs includes at least one trim-enable MTJ and at least one antifuse MTJ.

7. The magnetoresistive device of claim 6, wherein the at least one antifuse block is positioned adjacent the memory array.

8. The magnetoresistive device of claim 6 or 7, wherein a size of each of the plurality **of** MTJs in the memory array is different from a size of each of the trim-enable and antifuse MTJs in the at least one antifuse block, in particular wherein the plurality of MTJs in the memory array are placed on different wordlines and bitlines from those of the trim-enable and antifuse MTJs in the at least one antifuse block.

9. The magnetoresistive device of one of claims 6 to 8, wherein an area surrounding the at least one antifuse block is tiled with an MTJ fill pattern.

10. The magnetoresistive device of one of claims 6 to 9, further including:
a circuit configured to determine a logical state of each of the at least one trim-enable MTJ and at least one antifuse MTJ in each group,
wherein the logical state of the at least one antifuse MTJ in the group is read when the at least one trim-enable MTJ in the group has a second logical state, and wherein the logical state of the at least one antifuse MTJ is determined to be a first logical state when the at least one trim-enable MTJ has the first logical state.

11. The magnetoresistive device of one of claims 6 to 10, further including:
a circuit configured to determine a logical state of each of the at least one trim-enable MTJ and at least one antifuse MTJ,
wherein the circuit includes one or more scan-chains.

12. A method comprising:
selectively programming one or more antifuse bits, among a plurality of antifuse bits, to be in a second logical state, wherein a remainder of the plurality of antifuse bits are in a first logical state;
programming one or more trim-enable bits, among a plurality of trim-enable bits, to be in the second logical state, wherein a remainder of the plurality of trim-enable bits are in the first logical state; and
associating each of the plurality of trim-enable bits with a corresponding subset of the plurality of antifuse bits based on a logical state of the each of the plurality of trim-enable bits and the plurality of antifuse bits, such that any trim-enable bit that has the first logical state is associated with a corresponding subset of the plurality of antifuse bits that has the first logical state in its entirety, and any trim-enable bit that has the second logical state is associated with a corresponding subset of the plurality of antifuse bits that has at least one antifuse bit having the second logical state.

13. The method of claim 12, the method further comprising:
determining the logical state of each of the plurality of trim-enable bits to determine subsequent actions to be performed with respect to the corresponding subset of the plurality of antifuse bits, in particular wherein the method further comprises:
determining the logical state of each of the plurality of trim-enable bits; and
upon determining the logical state of a trim-enable bit is in the first logical state, determining that the corresponding subset of the plurality of antifuse bits have the first logical state in its entirety.

14. The method of claim 12 or 13, the method further comprising:
determining the logical state of each of the plurality of trim-enable bits; and
upon determining the logical state of a trim-enable bit is in the second logical state, reading the logical state of each antifuse bit in the corresponding subset of the plurality of antifuse bits.

15. The method of one of claims 12 to 14, wherein the one or more antifuse bits and the one or more trim-enable bits comprise one or more magnetic tunnel junctions (MTJs).
